# EUROPEAN PATENT SPECIFICATION

(11) **EP 3 940 122 B1**
(45) Date of publication and mention of the grant of the patent: **03.01.2024**
(21) Application number: 21182272.1
(22) Date of filing: 29.06.2021
(51) Int. Cl.: C30B 23/02, C30B 29/36

(54) **METHOD OF MANUFACTURING SIC WAFER**
VERFAHREN ZUR HERSTELLUNG EINES SIC-WAFERS
PROCÉDÉ DE FABRICATION DE PLAQUETTE DE SIC

(30) Priority: 14.07.2020 KR 20200086798
(43) Date of publication of application: 19.01.2022
(73) Proprietor: SENIC Inc., Chungcheongnam-do (KR)
(72) Inventor: PARK, Jong Hwi, 16205 Suwon-si, Gyeonggi-do (KR); KU, Kap Ryeol, 16336 Suwon-si, Gyeonggi-do (KR); KO, Sang Ki, 16356 Suwon-si, Gyeonggi-do (KR); KIM, Jung Gyu, 16327 Suwon-si, Gyeonggi-do (KR); JANG, Byung Kyu, 16332 Suwon-si, Gyeonggi-do (KR); CHOI, Jung Woo, 16328 Suwon-si, Gyeonggi-do (KR); KYUN, Myung Ok, 16327 Suwon-si, Gyeonggi-do (KR); SHIM, Jongmin, 18319 Hwaseong-si, Gyeonggi-do (KR)
(74) Representative: BCKIP Part mbB

(56) References cited:
- KR-B1- 102 104 751
- US-A1- 2017 321 345
- Cp-Handels-Gmbh: "Graphitlösungen für Hochtemperaturanwendungen", , 29 March 2013 (2013-03-29), XP055856242, Internet Retrieved from the Internet: URL:https://www.graphitprodukte.de/fileadm in/content/downloads/hochtemperatur-v10.pd f [retrieved on 2021-10-29]
- KENJI GOMI ET AL: "Residual stress estimation in SiC wafer using IR polariscope", 2008 INTERNATIONAL CONFERENCE ON ELECTRONIC MATERIALS AND PACKAGING : (EMAP 2008) ; TAIPEI, TAIWAN, 22 - 24 OCTOBER 2008 ; [IN CONJUNCTION WITH THE 3RD INTERNATIONAL MICROSYSTEMS, PACKAGING, ASSEMBLY AND CIRCUITS TECHNOLOGY CONFERENCE (IMPACT)], IEEE, 22 October 2008 (2008-10-22), pages 268-270, XP031425348, ISBN: 978-1-4244-3620-0

## Description

### BACKGROUND

### 1. Field

The present invention relates to a method of manufacturing a wafer.

### 2. Description of Background

Silicon Carbide (SiC) is a semiconductor having a wide band gab of 2.2 eV to 3.3 eV, and the research and development of which is proceeding as a semiconductor material due to the excellent physical and chemical properties.

As for a method of manufacturing a silicon carbide seed crystal, liquid phase epitaxy (LPE), chemical vapor deposition (CVD), and physical vapor transport (PVT) are present. Among them physical vapor transport (PVT) is a method of charging a silicon carbide material inside a crucible, disposing a seed crystal consisting of silicon, heating the crucible to sublimate by an induction heating method, and thereby growing a silicon carbide single crystal on a seed crystal.

Physical vapor transport (PVT) can manufacture a silicon carbide in an ingot shape with a high growth rate and thereby is being the most widely used process. However, current density changes and temperature distribution also changes depending on the properties of a crucible, the process condition, and so on, so that securing regular properties of a silicon carbide ingot and a wafer according to this is difficult.

KR 102 104 751 B1 discloses a method for manufacturing a silicon carbide ingot. A 4H SiC-containing silicon carbide ingot containing is produced by the following steps: a preparation step of disposing a raw material in a crucible body and a crucible cover on which a silicon carbide seed is located, wrapping the crucible body with a heat insulating material having a density of 0. 14-0.28 g/cc, and preparing a reaction vessel; and a growth step of positioning the reaction vessel in a reaction chamber and adjusting the inside of the reaction vessel to a crystal growth atmosphere to steam-transfer the raw material to face the silicon carbide seed and also to prepare the silicon carbide ingot grown from the silicon carbide seed.

### SUMMARY

One aspect of the present disclosure is related to providing a silicon carbide ingot and a wafer having a low retardation in polarization during a visible ray investigation, by controlling a process such as the density of an insulating material from a manufacturing process of a silicon carbide ingot and a wafer.

An object of the present invention is to provide a silicon carbide ingot and a wafer whose defect value such as dislocation density is lowered and the quality of which is good.

To this end, the present invention provides a method in accordance with claim 1.

In a general aspect of the disclosure, a wafer may have,
retardation distribution measured with light of a wavelength of 520 nm, and
wherein the average value of the retardation of 38 nm or less.

In a general aspect, a wafer has,
retardation distribution measured with light of a wavelength of 520 nm, and
wherein the maximum value of the retardation of 60 nm or less.

On one embodiment not covered by the claimed invention, the wafer comprises one side and the other side which is the opposite side thereof, and

the entire Ra average roughness of one side of the wafer may be less than 0.3 nm.

On one embodiment not covered by the claimed invention, the wafer may have a full width at half maximum (FWHM) value of 30 arcsec or less in a rocking curve according to XRD analysis.

On one embodiment not covered by the claimed invention, the wafer may have a diameter of 4 inch or more, and comprise a silicon carbide with 4H structure.

On one embodiment not covered by the claimed invention, the wafer may comprise a micropipe, wherein the density of the micropipe is 1.5 / cm² or less.

According to the invention, a method of manufacturing a wafer comprises,
a preparation step of disposing a material and a silicon carbide seed crystal to face each other in a reactor having inner space;
a growing step of adjusting the temperature, the pressure, and the atmosphere of the inner space to sublimate the material, and thereby preparing a silicon carbide ingot grown from the seed crystal;
a cooling step of cooling the reactor and retrieving the silicon carbide ingot;
a cutting step of cutting the retrieved silicon carbide ingot thereby preparing a wafer, the cutting step cutting the silicon carbide ingot to make a fixed off angle with the 0001 surface of the silicon carbide ingot, the angle being 0° to 10°; and
a processing step of flattening the thickness of the prepared wafer and polishing the surface;
wherein the reactor comprises an insulating material surrounding the external surface, and a heating mean for adjusting the temperature of the reactor or the inner space,
the density of the insulating material is 0.14 g/cc to 0.28 g/cc,
the thermal expansion of the insulating material is 2.65 × 10⁻⁶ /°C to 2.75 × 10⁻⁶ /°C at 1000°C, and
the wafer processed by the processing step may have retardation distribution measured with light of a wavelength of 520 nm, the wafer having a thickness of 200 to 600 µm, the retardation distribution being measured in a thickness direction of the wafer, and one or more from below i) and ii) items.
   i) The average value of the retardation is 38 nm or less; and
   ii) The maximum value of the retardation is 60 nm or less,
wherein the diameter of the wafer is 15.3 cm (6 inch) or less.

On one embodiment, the growing step allow the flow of an inert gas to proceed in a direction from the material to a silicon carbide seed crystal, and
the flow rate of the inert gas may be a value from 70 sccm to 300 sccm.

On one embodiment, a process for polishing the surface in the processing step may further comprise a chemical mechanical polishing step.

On one embodiment, a wafer processed by the processing step may have a full width at half maximum (FWHM) value of 30 arcsec or less in a rocking curve according to XRD analysis.

A wafer according as described above has advantages of having a low retardation value, not including distortion or twist of a crystal, and showing a good crystal quality.

A method of manufacturing a wafer can manufacture a silicon carbide ingot whose retardation value is secured and whose defect density value is lowered, by applying an insulating material in a certain density.

### BRIEF DESCRIPTION OF THE DRAWINGS

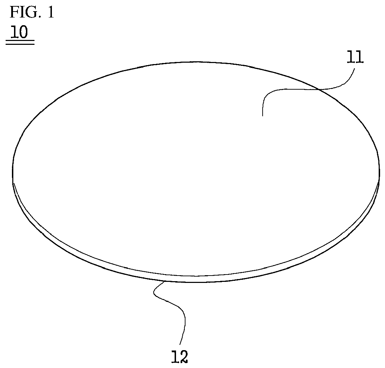

FIG. 1 is a conceptual view for showing one example of a wafer;
FIG. 2 is a conceptual view for showing one example of a manufacturing device of a silicon carbide ingot;
FIG. 3 is a conceptual view for showing one example of a silicon carbide ingot; and

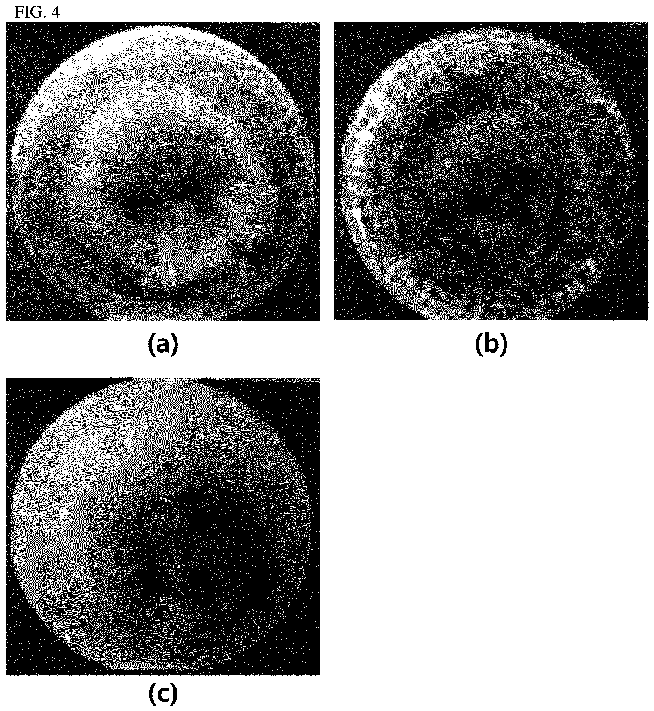

FIGs. 4 (a), (b), and (c) are respectively photos for visualizing the measured results for retardation of Example 2, Example 3, and Comparative Example 1 (GREY and auto-scale is applied as the color display, (a) is the result of applying a scale of black: 0.0 and white: 20.0, (b) is the result of applying a scale of black: 0.0 and white: 30.0, and (c) is the result of applying a scale of black: 0.0 and white: 40.0).

### DETAILED DESCRIPTION OF EXEMPLARY EMBODIMENTS

Hereinafter, example embodiments of the present invention will be described in detail with reference to the accompanying drawings so that they can be easily practiced by those skilled in the art to which the present invention pertains. The invention may, however, be embodied in many different forms and is not to be construed as being limited to the embodiments set forth herein. Like reference numerals designate like elements throughout the specification.

Throughout this disclosure, the phrase that a certain element "comprises" or "includes" another element means that the certain element may further include one or more other elements but does not preclude the presence or addition of one or more other elements, unless stated to the contrary.

Throughout this disclosure, it will be understood that when an element is referred to as being "connected" to another element, it can be directly connected to the other element or intervening elements may be present.

In this disclosure, "B being placed on A" means that B is placed in direct contact with A or placed over A with another layer or structure interposed therebetween and thus should not be interpreted as being limited to B being placed in direct contact with A, unless the description clearly dictates.

In this disclosure, the phrase "combination(s) thereof' included in a Markush-type expression denotes one or more mixtures or combinations selected from the group consisting of components stated in the Markush-type expression, that is, denotes that one or more components selected from the group consisting of the components are included.

In this disclosure, the description "A and/or B" means "A or B, or A and B."

In this disclosure, terms such as "first," "second," "A," or "B" are used to distinguish the same terms from each other. The singular forms "a," "an," and "the" include the plural form unless the context clearly dictates otherwise.

In this disclosure, a singular form is contextually interpreted as including a plural form as well as a singular form unless specially stated otherwise.

Hereinafter, example embodiments will be described in further detail.

Various factors such as material, atmosphere, and condition applied in a manufacturing process affect the quality of an ingot and a wafer. The crystal quality, the degree of defect occurrence, the residual stress, and so on of an ingot and a wafer can affect the performance, the properties, and the manufacturing process of elements manufactured into a wafer. Accordingly, though the crystal quality, the residual stress, and the defect may be evaluated as respective ingredients, they may be synthetically evaluated by being quantified or numericized and using a method of measuring retardation.

The inventors have conducted research on a method of manufacturing a silicon carbide ingot and a wafer having a better retardation distribution characteristic and reduced defects, with being excellent in the crystal quality. The inventors have verified that among various factors, a temperature gradation and properties of an insulating material is important in growth of a silicon carbide done by applying a physical vapor transport (PVT), and a silicon carbide ingot and a wafer with an excellent quality can be manufactured by controlling these conditions, and thus completed this invention.

### Wafer 10

A wafer 10 manufactured according to the invention has retardation distribution measured with light of a wavelength of 520 nm, and the average value of the retardation is 38 nm or less.

The wafer 10 manufactured according to the invention has the average value of retardation measured by light having a center wavelength of 520 nm entering a wafer in a thickness direction, and the average value of the retardation may be 38 nm or less.

The wafer comprises one side 11 and the other side 12 which is the opposite side of the one side.

The thickness direction may be a direction from the one side to the other side.

The one side of the wafer is so-called Si surface where silicon atoms mainly show in the surface, and the other side as an opposite side of the one side is so-called C surface where carbon atoms mainly show in the surface.

When cutting processing a wafer, the wafer may be easily cut in an interface between the layer of carbon atoms and the layer of silicon atoms that are haven by a silicon carbide single crystal, or in a direction parallel to the interface. Accordingly, a surface where carbon atoms are mainly exposed and a surface where silicon atoms are mainly exposed are allowed to show on the cross section.

Polishing of one side and/or the other side of a wafer proceeds in a process of manufacturing a wafer from an ingot. A wafer used for measuring retardation distribution may be a wafer the polishing of which is processed in both surfaces.

Retardation distribution inside a certain area may be measured by being visualized or quantified through a device such as WPA-200 or WPA-micro available from PHOTONIC LATTICE, INC. Example embodiments are based on the result measured with light of a wavelength of 520 nm by applying WPA-200 available from PHOTONIC LATTICE, INC.

The retardation refers to a value showing a difference of phases between before and after transmitting a polarized visible ray in a thickness direction of a target. When the target has residual stress, distortion, defects, or damage, variation occurs in the retardation distribution.

Even though in a clear target not having a birefringence characteristic, double refraction phenomenon may be observed when a certain stress and distortion are added to the target. Accordingly, evaluating a double refraction is one convenient method for evaluating residual stress and distortion quantitatively.

Retardation distribution is a parameter related to a phase retardation value of a target generated when polarized light is transmitted in a thickness direction. Occurrence of a phase difference means that a polarized state is changed. Additionally, the phase difference may be generated by various causes.

Birefringence is generally proportioned to retardation, so that retardation can be used as a parameter showing a degree of residual stress. Accordingly, when retardation distribution is within a certain range in an area overall, it can mean that the target has a stress regulated in the area overall. Particularly, when a target is formed with the substantially same material in a thickness direction, and the thickness of the target is substantially equal, the result can be more credible.

However, retardation distribution may be affected by other factors besides residual stress. For example, retardation distribution may be changed by distortion and defects such as dislocation, and may also be affected by a degree of crystallinity in a case of crystalline substance. Also, retardation distribution may be changed by defects such as a fine crack generated in a target.

That is, evaluation of retardation distribution of a wafer is thought to be a method for simultaneously evaluating a degree of residual stress, whether distortion occurs, whether defects occur, excellence of crystal, whether damage from the external impact easily occurs, and is utilized as an index for confirming whether various characteristics required for a wafer manufactured in example embodiments are all excellent.

The average value of the retardation of the wafer 10 may be 38 nm or less. The average value of the retardation of the wafer may be 30 nm or less, or 20 nm or less. The average value of the retardation of the wafer may be 15 nm or less. The average value of the retardation of the wafer may be 0.1 nm or more. The average value of the retardation of the wafer may be 5 nm or more. A wafer having such a retardation value can have a state of being minimized for distortion or defects of the inner crystal, and improved properties when applied as a semiconductor element.

The maximum value of the retardation of the wafer 10 may be 60 nm or less, 45 nm or less, or 42.8 nm or less.

The minimum value of the retardation of the wafer 10 may be less than 0.10 mm, 0.08 mm or less, or 0.02 mm or less.

The standard deviation of the retardation of the wafer 10 in a thickness of the wafer may be 30 nm or less, 20 nm or less, or 12 nm or less. The deviation of retardation may be 1 nm or more.

A wafer having these maximum value, minimum value, and standard deviation of retardation can have an inner lattice minimized in distortion or defects, and the distribution can be shown more stably.

The wafer 10 may be prepared by cutting a silicon carbide ingot described below.

The wafer may have a rocking angle of -1.5 ° to 1.5 °, -1.0 ° to 1.0 °, -0.5 ° to 0.5 °, or - 0.3 ° to 0.3 °. A wafer having such a characteristic can have an excellent crystalline characteristic. The rocking angle is set by applying a high-resolution X-ray diffraction analysis system (HR-XRD system) to evaluate crystallinity according to a following method. The direction of the wafer [11-20] is fitted to an X-ray route, the angles of X-ray source optic and X-ray detector optic are set to be 2 θ (35 ° to 36 °), and thereafter omega (ω, or θ as an X-ray detector optic) angle is adjusted to be fitted with an off angle of a wafer for measuring a rocking curve, wherein the difference values between a peak angle as a reference angle and two full width at half maximum (FWHM) values are respectively set as rocking angles to evaluate crystallinity.

In this disclosure, mentioning an off angle is X ° means having an off angle evaluated as X ° within the margin of error generally permitted, and for example, comprises an off angle in a range of (X ° - 0.05 °) to (X ° + 0.05 °). In addition, mentioning a rocking angle is "-1 ° to 1 ° compared to a reference angle" means that a full width at half maximum value is within a range of (peak angle - 1 °) to (peak angle + 1 °) based on the peak angle as a reference angle. Moreover, for the rocking angle, a surface excepting for the center and portions within 5 mm from the edges to the center is trisected to be substantially equal, and the result of measuring three times or more in respective portions was averaged to be treated as the above rocking angle. In detail, among wafers applied with an off angle which is an angle selected in a range of 0 ° to 10 ° against (0001) surface of a silicon carbide ingot, when the off angle is 0 °, the omega angle is 17.8111 °, when the off angle is 4 °, the omega angle is 13.811 °, and when the off angle is 8 °, the omega angle is 9.8111 °.

The wafer 10 may have a full width at half maximum value (FWHM) of rocking curve of 30 arcsec or less, or 27.4 arcsec or less according to XRD analysis. The wafer may have a full width at half maximum value of rocking curve of 3.5 arcsec or more according to XRD analysis. When a defect is present in a crystal of a wafer, the strength of a diffracting X-Ray shows gaussian distribution and this is referred to as a rocking curve. The full width at half maximum value of the rocking curve has a unit of arcsec, and when the full width at half maximum value is large it is thought to have many crystal defects. A wafer having these ranges of the full width at half maximum can show excellent crystallinity and improve properties of elements manufactured through the same.

The wafer 10 may have a micropipe (MP) density of 1.5 /cm² or less, or 1 /cm² or less. The wafer 10 may have a threading edge dislocation (TED) density of 10,000 /cm² or less, or 8,000 /cm².

The wafer 10 may have a basal plane dislocation (BPD) density of 5,000 /cm² or less, or 3,000 /cm² or less.

The thickness of the wafer 10 may be 150 µm to 900 µm, or 200 µm to 600 µm, but not limited thereto and any proper thickness applicable to a semiconductor element can be applied.

The wafer 10 may be a silicon carbide wafer, and may be a wafer substantially comprising a 4H silicon carbide which is a single crystal.

In a broad aspect not covered by the invention, the diameter of the wafer 10 may be 4 inch or more, 5 inch or more, or 6 inch or more. In a broad aspect not covered by the invention, the diameter of the wafer may be 12 inch or less, or 10 inch or less. According to the invention, the diameter is 6 inch or less.

The entire Ra average roughness of one side 11 of the wafer may be less than 0.3 nm, or 0.2 nm or less. The entire Ra average roughness of the one side may be 0.01 nm or more. A wafer having these ranges of roughness can improve electric properties when manufactured into an element through subsequent processes.

The wafer 10 may be manufactured by a method of manufacturing a wafer described below.

### Method of Manufacturing a Wafer

According to the invention, a method of manufacturing a wafer comprises,
a preparation step of disposing a material 300 and a silicon carbide seed crystal to face each other in a reactor 200 having an inner space;
a growing step of adjusting the temperature, the pressure, and the atmosphere of the inner space to sublimate the material, and thereby preparing a silicon carbide ingot grown from the seed crystal;
a cooling step of cooling the reactor and retrieving the silicon carbide ingot;
a cutting step of cutting the retrieved silicon carbide ingot thereby preparing a wafer, the cutting step cutting the silicon carbide ingot to make a fixed off angle with the 0001 surface of the silicon carbide ingot, the angle being 0° to 10°; and
a processing step of flattening the thickness of the prepared wafer and polishing the surface;
wherein the reactor comprises an insulating material surrounding the external surface, and a heating mean for adjusting the temperature of the reactor or the inner space, and
the density of the insulating material is 0.14 g/cc to 0.28 g/cc.

The preparation step is for disposing a material 300 and a silicon carbide seed crystal to face each other in a reactor 200 having an inner space.

The silicon carbide seed crystal in the preparation step may be one with a proper size depending on a desired wafer, and a C surface ((000-1) surface) of the silicon carbide seed crystal can be toward a direction of the material 300.

The material 300 in the preparation step may be a powder form having carbon sources and silicon sources, and the powder may be a material treated by necking from each other or a silicon carbide powder whose surface is treated with carbonization.

The reactor 200 in the preparation step may be any container which is proper for growing reaction of a silicon carbide ingot, and in detail a graphite crucible may be applied. For example, the reactor may comprise a body 210 comprising an inner space and an opening part and a cover 220 corresponding the opening par and thereby closing the inner space. The crucible cover may further comprise a seed crystal holder in one body or separated with the crucible cover, and can fix a silicon carbide seed crystal to allow a silicon carbide seed crystal and a material to face each other through the seed crystal holder.

The reactor 200 in the preparation step may be surrounded and fixed by an insulating material 400, the insulating material surrounding the reactor may be placed inside a reaction chamber 500 like a quartz tube, and the temperature of the inner space of the reactor 200 may be controlled by a heating mean 600 equipped in the external of the insulating material and the reaction chamber.

In examples not covered by the claimed invention, the insulating material 400 in the preparation step may have a coefficient of thermal expansion of 2.65×10⁻⁶ /°C to 3.05×10⁻⁶ /°C, 2.7×10⁻⁶ /°C to 3×10⁻⁶ /°C, or 2.75×10⁻⁶ /°C to 2.9×10⁻⁶ /°C at 1000 °C. The coefficient of thermal expansion may be the average of coefficients of thermal expansion in a first direction which is one direction of the insulating material, a second direction perpendicular to the first direction, and a third direction perpendicular to the first direction and the second direction. By applying an insulating material having such a coefficient of thermal expansion, a proper distribution of residual stress can be obtained, and retardation distribution in a thickness direction measured with a visible ray in a wafer can have a good value.

The coefficient of thermal expansion can be identified by measuring length variation depending on the reference temperature. In detail, it can be identified by cutting an insulating material as a measuring target in a size of 5×5×5 mm³ for preparing a measuring sample, and measuring length variation against the reference temperature by using TMA Q400 available from TA INSTRUMENTS INC, and the coefficient of thermal expansion may be a value at 1000 °C.

The insulating material 400 in the preparation step may have a porosity of 72 % to 95 %, 75 % to 93 %, or 80 % to 91 %. When applying an insulating material satisfying the above porosity, it is possible to decrease crack occurrence of a silicon carbide ingot to be grown.

The insulating material 400 in the preparation step may have a compressive strength of 0.2 MPa or more, 0.48 MPa or more, or 0.8 MPa or more. Also, the insulating material may have a compressive strength of 3 MPa or less, or 2.5 MPa or less. When the insulating material has such a compressive strength, it is possible to manufacture a silicon carbide ingot excellent in thermal/mechanical stability and having a more excellent quality due to a decreased possibility of generating ash.

The insulating material 400 in the preparation step may comprise a carbon-based felt, and in detail, may comprise a graphite felt, a rayon-based graphite felt, or a pitch-based graphite felt.

The insulating material 400 in the preparation step has a density of 0.14 g/cc or more, 0.16 g/cc or more, or 0.17 g/cc or more. The insulating material has a density of 0.28 g/cc or less, 0.24 g/cc or less, or 0.20 g/cc or less. By an insulating material having the above density ranges, a bend and a twist can be prevented in an ingot to be manufactured, and a good retardation value can be shown in a wafer manufactured from the ingot.

A reaction chamber 500 in the preparation step may comprise a vacuum exhauster 700 connected to the internal of the reaction chamber and regulating the vacuum degree of the internal of the reaction chamber, a pipe 810 connected to the internal of the reaction chamber and allowing gas to flow into the internal of the reaction chamber, and a mass flow controller 800 for control. Through them, the flow rate of an inert gas can be regulated in subsequent growing step or cooling step.

The growing step is for adjusting the temperature, the pressure, and the air atmosphere of the inner space to sublime the material and thereby preparing a silicon carbide ingot grown from the seed crystal.

The growing step can proceed by the heating mean 600 heating the reactor 200 and the inner space of the reactor, and can induce growing of a silicon carbide crystal by depressurizing the inner space simultaneously or separately with heating to adjust the vacuum degree and introducing an inert gas.

The growing step may proceed in a condition of a temperature of 2000 °C to 2600 °C and a pressure of 1 torr to 200 torr, and it is possible to manufacture a silicon carbide ingot more efficiently in the above ranges of temperature and pressure.

In detail, the growing step may proceed in a condition in which a temperature in surfaces of an upper portion and a lower portion of the reactor 200 is 2100 °C to 2500 °C, and a pressure of the inner space of the reactor is 1 torr to 50 torr, and in further detail, in a condition in which a temperature in surfaces of an upper portion and a lower portion of the reactor 200 is 2150 °C to 2450 °C, and a pressure of the inner space of the reactor is 1 torr to 40 torr, and more specifically, in a condition in which a temperature in surfaces of an upper portion and a lower portion of the reactor 200 is 2150 °C to 2350 °C, and a pressure of the inner space of the reactor is 1 torr to 30 torr.

When the condition of temperature and pressure is applied to the growing step, a silicon carbide ingot in a higher quality can be manufactured.

The growing step may allow heating to proceed in a heating rate of 1 °C/min to 10 °C/min, or 5 °C/min to 10 °C/min to the above temperature range.

The growing step may add an inert gas in a fixed flow rate to the external of the reactor 200. The inert gas may flow in the inner space of the reactor 200, and may flow in a direction from the material 300 to the silicon carbide seed crystal. Accordingly a stable temperature gradation can be formed in the reactor and the inner space.

The flow rate of the inert gas in the growing step may be 70 sccm or more, or 330 sccm or less. Defect occurrence of an ingot manufactured in this range of flow rate can be minimized, and a desired retardation value can be shown by forming temperature gradation of a reactor and an inner space effectively.

The inert gas in the growing step may be specifically argon, helium, or a mixture thereof.

The cooling step is for cooling the grown silicon carbide ingot in a condition of a fixed cooling rate and a flow rate of an inert gas.

The cooling step may allow cooling to proceed in a rate of 1 °C/min to 10 °C/min, or 1 °C/min to 5 °C/min.

The cooling step may simultaneously regulate a pressure of the inner space of the reactor 200, or a pressure may be regulated separately from the cooling step. The pressure may be regulated to have maximum 760 torr for the pressure of the inner space.

The flow rate of an inert gas in the cooling step may be 1 sccm or more, or 300 sccm or less. Crack occurrence can be prevented, and the quality degradation can be minimized in an ingot manufactured in this range of flow rate.

The cooling step may add an inert gas in a fixed flow rate to the external of the reactor 200 to be like the growing step. The inert gas may flow in the inner space of the reactor, or may flow in a direction from the material 300 to the silicon carbide seed crystal.

The cutting step is for cutting the silicon carbide ingot retrieved after the cooling step and thereby preparing a wafer.

The cutting step cuts the silicon carbide ingot to make a fixed off angle with the (0001) surface of the silicon carbide ingot. The off angle in the cutting step is 0 ° to 10 °.

The cutting step allows the thickness of the wafer to be 200 µm to 600 µm.

The processing step is for flattening the thickness of a wafer prepared through the cutting step and polishing the surface. The process for flattening the thickness may be made by applying wheel grinding to both side of a wafer in order. A polishing material used for the wheel grinding may be a diamond polishing material.

Through the process of flattening the thickness in the processing step, damage and stress added to a wafer in the cutting step are reduced and the wafer is made to be flat.

The process of polishing the surface in the processing step may further comprise chemical mechanical polishing (CMP).

The chemical mechanical polishing process may be made by adding slurry of polished particles on a rotating plate and contacting the fixed wafer to a rotating polishing head in a fixed pressure.

A washing step using a general RCA chemical washing solution may be further made after the processing step.

### Silicon Carbide Ingot 100

In a general aspect, a silicon carbide ingot 100 according to example embodiments may comprise,
one side 110 and the other side 120 facing each other,
wherein the one side defined as an upper portion may be a flat surface or a convex surface,
a wafer may be prepared in a portion below the one side,
the wafer may have retardation distribution measured with light of a wavelength of 520 nm, and the retardation may have the average value of 35 nm or less.

The silicon carbide ingot 100 is grown by a material inside a reactor which is sublimed and recrystallized on a silicon carbide seed crystal.

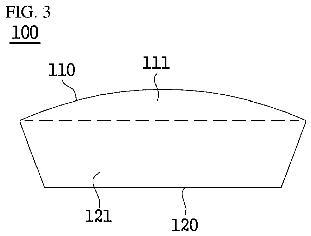

Referring to FIG. 3, a surface directing the material within surfaces of the silicon carbide ingot after being completed of growing may be one side 110, and the one side may have a curved convex surface or a flat surface.

The silicon carbide ingot 100 may comprise a body 121 and a convex part 111 extended from the body and having a convex surface. When the convex surface of the silicon carbide ingot is designated as an upper portion, a portion below the convex surface may correspond to the body.

That is, when one side 110 of the silicon carbide ingot is designated as an upper portion, a bottom surface where growing of a silicon carbide ingot has started may be designated as the other side 120, the other side may be designated as a lower portion, and a portion below the one side may be cut in a fixed thickness to prepare a wafer. In this time, a fixed off angle may be made with the other side or (0001) surface of the silicon carbide ingot.

In addition, as a process of preparing the wafer, a direction from an outside diameter to an inside diameter may be trimmed by using a grinding device in the outside diameter of the silicon carbide ingot 100, and cut in a fixed thickness and a fixed off angle against the other side or (0001) surface of the silicon carbide ingot for proceeding of grinding the edges, polishing the surface, or processing such as polishing.

The silicon carbide ingot 100 may be grown from a C surface ((000-1) surface) of a silicon carbide seed crystal.

The silicon carbide ingot 100 may be manufactured through a crucible satisfying a certain thermal conductivity in a growing step and a cooling step during the manufacture.

Hereinafter, the present application will be described in further detail. Below example embodiments are only examples for helping comprehension of the present application, and the range of the present application is not limited thereto.

### <Example 1 - Manufacture of Wafer>

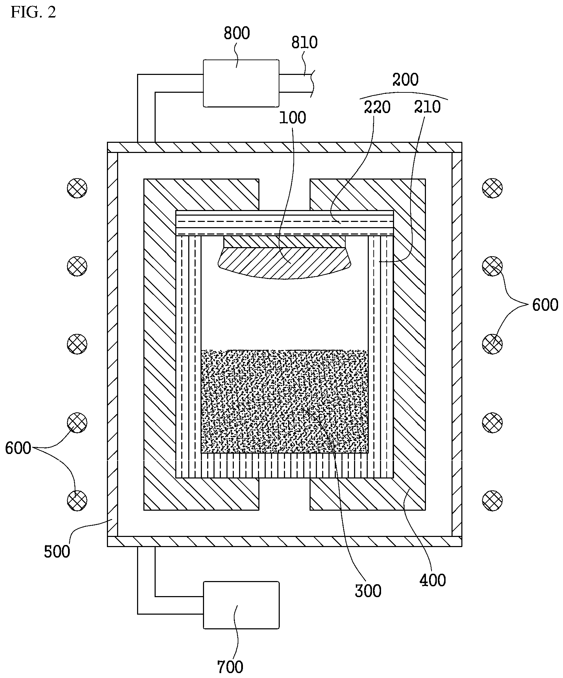

Like an illustration of an example of a device of manufacturing a silicon carbide ingot in FIG. 2, a silicon carbide powder as a material was charged in a lower portion of an inner space of a reactor 200, and a silicon carbide seed crystal was disposed in an upper portion thereof. In this time, a silicon carbide seed crystal consisting of a 4H-SiC crystal with 6 inch was applied, fixed in a general method for a C surface ((000-1) surface) to be toward the silicon carbide material in a lower portion of the inner space, and applied in below examples and comparative examples to be the same.

A reactor 200 was sealed up, the outside thereof was surrounded with an insulating material 400 having a density of 0.15 g/cc and a coefficient of thermal expansion of 2.80 × 10⁻⁶ /°C, and after that the reactor was disposed inside a quartz tube 500 equipped with a heating coil as a heating mean 600 in the outside. The inner space of the reactor was depressurized to be a vacuum atmosphere, argon gas was introduced to the inner space to reach 760 torr, and the inner space was depressurized again. At the same time, the temperature of the inner space was heated to 2300 °C in a heating rate of 5 °C/min, and the flow rate of argon gas inside a quartz tube was adjusted through a pipe and a vacuum degassing device 700 connected to the quartz tube. A silicon carbide ingot was allowed to be grown on a surface of a silicon carbide seed crystal opposite to a silicon carbide material for 100 hours under a condition of a temperature of 2300 °C and a pressure of 20 torr.

After growing of the silicon carbide ingot, the temperature of the inner space was cooled to 25 °C in a rate of 5 °C/min, and at the same time the pressure of the inner space was to be 760 torr.

A wafer sample which was cut to have an off angle of 4 ° against (0001) surface of the cooled silicon carbide ingot and had a thickness of 360 µm was prepared, the edge of this wafer was ground by 5 % against the maximum outside diameter, and subsequently general chemical mechanical polishing and RCA washing was performed.

### <Example 2 - Manufacture of Wafer>

A wafer was manufactured by the same method as the Example 1 excepting for being changed in the density of the insulating material to be 0.16 g/cc and the coefficient of thermal expansion to be 2.75 ×10⁻⁶ /°C from the Example 1.

### <Example 3 - Manufacture of Wafer>

A wafer was manufactured by the same method as the Example 1 excepting for being changed in the density of the insulating material to be 0.17 g/cc and the coefficient of thermal expansion to be 2.9 ×10⁻⁶ /°C from the Example 1.

### <Comparative Example 1 - Manufacture of Wafer>

A wafer was manufactured by the same method as the Example 1 excepting for being changed in the density of the insulating material to be 0.13 g/cc and the coefficient of thermal expansion to be 2.6 ×10⁻⁶ /°C from the Example 1.

### <Comparative Example 2 - Manufacture of Wafer>

A wafer was manufactured by the same method as the Example 1 excepting for being changed in the density of the insulating material to be 0.29 g/cc and the coefficient of thermal expansion to be 3.1 ×10⁻⁶ /°C from the Example 1.

### <Experimental Example - Measurement of Retardation and the Full Width at Half Maximum Value of Wafer>

The prepared wafer sample was measured for the average value, the minimum value, and the maximum value of retardation in a thickness direction of a wafer by using WPA-200 device (available from PHOTONIC LATTICE, INC) with light of a wavelength of 520 nm, and the result was shown in Table 1 and some of the result was shown in Table 4. And then the full width at half maximum value of the rocking curve of the wafer sample was measured through a XRD analyzing device (SmartLab X-ray Diffractometer available from RIGAKU), and the result was shown in Table 1.

**[Table 1]**

| | Density of Insulating Material (g/cc) | Coefficient of Thermal Expansion (×10⁻⁶)/°C (@1000°C) | The Average of Retardation (nm) | The Minimum Value of Retardation (nm) | The Maximum Value of Retardation (nm) | The Average of the Full Width at Half Maximum Value (arcsec) |
|---|---|---|---|---|---|---|
| Example 1 | 0.15 | 2.80 | 20 | 0.01 | 25.06 | - |
| Example 2 | 0.16 | 2.75 | 19 | 0.08 | 42.74 | 27.4 |
| Example 3 | 0.17 | 2.9 | 15 | 0.02 | 42.72 | 26.7 |
| Comparative Example 1 | 0.13 | 2.6 | 40 | 0.12 | 69.27 | 65.3 |
| Comparative Example 2 | 0.29 | 3.1 | 41 | 0.10 | 80.66 | - |

Referring to Table 1, it was verified that Examples having a density of an insulating material within a range of 0.14 g/cc to 0.28 g/cc, and a coefficient of thermal expansion within a range of 2.65×10⁻⁶ /°C to 3.05×10⁻⁶ /°C had a retardation value of 35 nm or less and the full width at half maximum value of the X-Ray rocking curve of 30 arcsec or less, so that show excellent crystal quality whose residual stress distribution was good and whose distortion occurrence, defects, and so on were reduced compared to comparative examples having a density of insulating material and a coefficient of thermal expansion outside these ranges.

## Claims

1. A method of manufacturing a wafer comprising:
a preparation step of disposing a material and a silicon carbide seed crystal to face each other in a reactor having an inner space;
a growing step of adjusting the temperature, the pressure, and the atmosphere of the inner space to sublime the material and thereby preparing a silicon carbide ingot grown from the seed crystal;
a cooling step of cooling the reactor and retrieving the silicon carbide ingot;
a cutting step of cutting the retrieved silicon carbide ingot to prepare a wafer, the cutting step cutting the silicon carbide ingot to make a fixed off angle with the 0001 surface of the silicon carbide ingot, the angle being 0° to 10°; and
a processing step of flattening the thickness or the prepared wafer and polishing the surface,
wherein the reactor comprises an insulating material surrounding the external surface, and a heating mean for adjusting the temperature of the reactor or the inner space,
wherein the density of the insulating material is 0.14 g/cc to 0.28 g/cc,
the coefficient of thermal expansion of the insulating material is 2.65×10⁻⁶ /°C to 2.75×10⁻⁶ /°C at 1000°C, and
the wafer processed by the processing step has retardation distribution measured with light of a wavelength of 520 nm, the wafer having a thickness of 200 to 600 µm, the retardation distribution being measured in a thickness direction of the wafer, and one or more between below i) and ii) items:
i) the average value of the retardation is 38 nm or less; and
ii) the maximum value of the retardation is 60 nm or less,
wherein the diameter of the wafer is 15.3 cm (6 inch) or less.

2. The method of manufacturing a wafer of claim 1,
wherein the growing step allows an inert gas to flow in a direction from the material to a silicon carbide seed crystal, and
the flow rate of the inert gas is from 70 sccm to 300 sccm.

3. The method of manufacturing a wafer of claim 1,
wherein the process for polishing the surface in the processing step further comprises a chemical mechanical polishing step.

## Patentansprüche

1. Verfahren zur Herstellung eines Wafers, umfassend:
einen Vorbereitungsschritt, bei dem ein Material und ein Siliciumcarbid-Keimkristall so angeordnet werden, dass sie einander in einem Reaktor mit einem Innenraum gegenüberliegen;
einen Züchtungsschritt, bei dem die Temperatur, der Druck und die Atmosphäre des Innenraums eingestellt werden, um das Material zu sublimieren und dadurch einen aus dem Impfkristall gezüchteten Siliciumcarbidblock herzustellen;
einen Abkühlungsschritt, bei dem der Reaktor abgekühlt und der Siliziumkarbidblock entnommen wird;
einen Schneideschritt zum Schneiden des entnommenen Siliciumcarbidrohlings zur Herstellung eines Wafers, wobei der Siliciumcarbidrohling so geschnitten wird, dass er einen festen Abwinkelungswinkel mit der Oberfläche 0001 des Siliciumcarbidrohlings bildet, wobei der Winkel 0° bis 10° beträgt; und
einen Verarbeitungsschritt des Abflachens der Dicke oder des vorbereiteten Wafers und des Polierens der Oberfläche,
wobei der Reaktor ein Isoliermaterial, das die Außenfläche umgibt, und ein Heizmittel zum Einstellen der Temperatur des Reaktors oder des Innenraums umfasst,
wobei die Dichte des Isoliermaterials 0,14 g/cc bis 0,28 g/cc beträgt,
der Wärmeausdehnungskoeffizient des Isoliermaterials 2,65 × 10-6 /°C bis 2,75 × 10-6 /°C bei 1000°C beträgt, und
der durch den Verarbeitungsschritt verarbeitete Wafer eine mit Licht einer Wellenlänge von 520 nm gemessene Retardationsverteilung aufweist, wobei der Wafer eine Dicke von 200 bis 600 µm aufweist, die Retardationsverteilung in einer Dickenrichtung des Wafers gemessen wird, und einer oder mehrere der folgenden Punkte i) und ii) erfüllt sind:
i) der Durchschnittswert der Retardierung beträgt 38 nm oder weniger; und
ii) der Maximalwert der Verzögerung beträgt 60 nm oder weniger,
wobei der Durchmesser des Wafers 15,3 cm (6 Zoll) oder weniger beträgt.

2. Verfahren zur Herstellung eines Wafers nach Anspruch 1,
wobei der Züchtungsschritt es einem Inertgas ermöglicht, in einer Richtung vom Material zu einem Siliziumkarbid-Keimkristall zu strömen, und
die Strömungsgeschwindigkeit des Inertgases zwischen 70 sccm und 300 sccm liegt.

3. Verfahren zur Herstellung eines Wafers nach Anspruch 1,
wobei das Verfahren zum Polieren der Oberfläche in dem Verarbeitungsschritt ferner einen chemischmechanischen Polierschritt umfasst.

## Revendications

1. Procédé de fabrication d'une tranche, comprenant :
une étape de préparation par disposition en vis-à-vis d'un matériau et d'un germe cristallin de carbure de silicium dans un réacteur pourvu d'un espace intérieur ;
une étape de croissance par réglage de la température, de la pression et de l'atmosphère de l'espace intérieur afin de sublimer le matériau et de préparer ainsi un lingot de carbure de silicium provenant du germe cristallin ;
une étape de refroidissement par refroidissement du réacteur et extraction du lingot de carbure de silicium ;
une étape de découpe du lingot de carbure de silicium extrait afin de préparer une tranche, ladite étape de découpe du lingot de carbure de silicium permettant d'obtenir un angle fixe d'ouverture avec la surface 0001 du lingot de carbure de silicium, ledit angle étant compris entre 0° et 10° ; et
une étape de traitement par aplatissement de l'épaisseur ou de la tranche préparée et polissage de surface,
où le réacteur comprend un matériau isolant entourant la surface extérieure, et un moyen de chauffage pour régler la température du réacteur ou de l'espace intérieur,
où la densité du matériau isolant est comprise entre 0,14 g/cm³ et 0,28 g/cm³,
le coefficient de dilatation thermique du matériau isolant est compris entre 2,65×10⁻⁶/°C et 2,75×10⁻⁶/°C à 1000 °C, et
la tranche traitée lors de l'étape de traitement a une distribution de retard mesurée avec une lumière de longueur d'onde de 520 nm, la tranche ayant une épaisseur comprise entre 200 et 600 µm, la distribution de retard étant mesurée dans le sens de l'épaisseur de la tranche, et une ou les deux caractéristiques i) et ii) ci-dessous :
i) la valeur moyenne du retard est égale ou inférieure à 38 nm ; et
ii) la valeur maximale du retard est égale ou inférieure à 60 nm, le diamètre de la tranche étant égal ou inférieur à 15,3 cm (6 pouces).

2. Procédé de fabrication d'une tranche selon la revendication 1,
où l'étape de croissance permet à un gaz inerte de s'écouler dans une direction depuis le matériau vers un germe cristallin de carbure de silicium, et
le débit du gaz inerte est compris entre 70 sccm et 300 sccm.

3. Procédé de fabrication d'une tranche selon la revendication 1,
où le processus de polissage de surface lors de l'étape de traitement comprend en outre une étape de polissage chimico-mécanique.
